# EUROPEAN PATENT APPLICATION

(11) **EP 4 571 327 A1**
(43) Date of publication of application: **18.06.2025**
(21) Application number: 24218503.1
(22) Date of filing: 09.12.2024
(51) Int. Cl.: G01R 19/165, G01R 31/40

(54) **ERRONEOUS POWER ADAPTER DETECTION SYSTEM**

(30) Priority: 15.12.2023 PT 2023119135
(71) Applicant: Altice Labs, S.A., 3810-106 Aveiro (PT)
(72) Inventor: VALE E SERRA, JOAQUIM FERNANDO, 3810-106 Aveiro (PT)
(74) Representative: Arnaut, José Luis

(57) **Abstract**

The present invention relates to the field of general electronic devices powered by an external power adapter (2). It addresses the problem of mismatching power adapters (2) with the corresponding electronic devices (4) when basic power adapters (2) are used. It uses a combination of hardware and software to test the connected power adapter (2). This is achieved by loading the power adapter (2) with a load (10) that corresponds to the maximum power required by the electronic device (4) and measuring using a voltage monitoring circuit (8) and ADC (9) if the power adapter (2) output voltage is within the required tolerance.

## Description

### FIELD OF THE INVENTION

The present invention relates to the field of general electronic devices powered by an external power adapter. It addresses the problem of mismatching the power adapter with the corresponding electronic device.

### PRIOR ART

Electronic devices that are not directly interfaced with the primary Alternating Current (AC) power grid typically derive their power from an external power adapter. These power adapters can be broadly classified into two categories:

### • Basic Power Adapters

The majority of power adapters employed in today's world are basic. They are designed to deliver the device with the exact voltage and current as stipulated by the device's specifications, without any kind of advanced features.

### • Advanced Power Adapters

These are technologically advanced power adapters that are equipped with a dedicated communication channel. This unique feature facilitates a negotiation between the adapter and the device regarding the parameters of power delivery. This negotiation process is crucial in averting any potential discrepancies in power supply, thereby ensuring the device's optimal performance.

To ensure the compatibility of the power adapter with the electronic device, various methodologies have been employed:

### • Labelling

Labels are affixed to both the power adapter and the device, indicating the required power capabilities. However, this method does not necessarily prevent a mismatch of the power adapter.

### • Distinct Connectors

The use of distinct connectors for different devices and power adapters is another approach. This method ensures that a mismatch of the power adapter is impossible due to the unique connector design for each device.

### • Additional Pins

Some power adapters incorporate extra pins in their design. These additional pins facilitate the implementation of a communication protocol, which allows the device to negotiate the parameters of power delivery. This advanced feature significantly reduces the likelihood of a power adapter mismatch, ensuring optimal device performance.

### PROBLEM TO BE SOLVED

The primary attribute of a basic power adapter is the amount of power it can supply to the load. Electronic devices with varying power levels necessitate the use of diverse power adapters, each with distinct power capabilities.

Given the limitless power requirements of an infinite array of electronic devices, there is a corresponding need for an equally extensive variety of power adapters. Manufacturers, to optimize the bill of materials and reduce the cost of the power adapter, typically employ the most basic connector for different power adapters. For instance, power adapters with capacities of 12W, 24W, 36W, 48W, etc may all utilize the same type of connector, thereby streamlining the manufacturing process and reducing costs.

If a user possesses two distinct power adapters, each with different power capabilities but with identical connectors, and intended for different electronic devices, there exists a potential for a mismatch. For instance, a scenario may arise where a power adapter with lower power capabilities is inadvertently used with an electronic device that necessitates higher power capabilities.

If the power output of the incorrectly matched power adapter is sufficient to meet the electronic device's minimum power requirement but cannot satisfy its maximum power requirement, the electronic device may exhibit unusual behaviors. These behaviors may not be immediately identifiable, leading to a multitude of issues and an influx of avoidable support calls. This situation underscores the importance of correctly matching power adapters to their corresponding electronic device to ensure optimal performance and avoid unnecessary complications.

The primary objective of this invention is to equip the electronic device with the ability to ascertain whether the connected power adapter possesses the necessary power capability. This is achieved without the need for any supplementary pins in the connection interface between the power adapter and the electronic device. This innovative approach enhances the electronic device's adaptability and ensures optimal performance while maintaining the simplicity of the connection interface.

### SUMMARY OF THE INVENTION

The present invention discloses a system to detect the connection of an erroneous power adapter to an electronic device. In its most generic embodiment, the system comprises a device to be implemented in the electronic device and a method to detect both adapted to detect if the power adapter has the required power capacity.

Upon the initial activation of the electronic device, the Microcontroller Unit (MCU) will be energized. It will subsequently execute a series of requisite evaluations to ascertain the capabilities of the power adapter. This process involves subjecting the power adapter to an equivalent load that corresponds to the peak power consumption of the electronic device, followed by a measurement of the output voltage of the power adapter.

This evaluation is conducted within the minimal duration necessary to deplete any capacitors present in the output of the power adapter. If the measured voltage is below the stipulated tolerance level of the required power adapter, it is inferred that the power adapter is not suitable for the device. Consequently, any pre-programmed measures can be initiated to address this discrepancy. This approach ensures the optimal operation of the electronic device and safeguards it against potential power-related issues.

The main and most generic embodiment of the present invention discloses an erroneous power adapter detection device, comprising:
- A diode module (5) disposed in between the power storage (6) and the main power rail (15) adapted to allow the flow solely in the direction of the power storage (6);
- A power storage (6) disposed between to the MCU power supply (7) and said diode module (5) ;
- A MCU power supply unit (7) disposed between the power storage (6) and the MCU (7);
- A voltage monitoring circuit (8) adapted to deliver a signal proportional to the electronic device input to the MCU (13) and disposed between the main power rail (15) and the MCU (13);
- A load (10) connected to the main power rail (15) and to an electronically controlled switch (11), said switch connected to the main power rail return (15);

- A MCU (13) connected to the voltage monitoring circuit (8) and the load (10) adapted to perform the erroneous power detection method;
- an ADC (9) adapted to perform analog-to-digital conversion of the voltage signal;
- two electronically controlled switches L (11) disposed between the load (10) and the main power rail (15) and M (12) disposed between the main power rail (15) and the electronic device's main power rail (14).

In an advantageous embodiment of the present invention, the erroneous power detection device further discloses a load (10) which is connected to the main power rail (15) through means of an electronically controlled switch (11).

In yet another advantageous embodiment of the device according the power storage (6) is a capacitor or any equivalent circuit.

In a further embodiment of the device the voltage monitoring circuit (7) is a resistive voltage divider with a transient voltage suppressor adapted to protect the MCU (13) from power spikes.

Advantageously, the load (10) is a resistor with a low sustained power capability adapted to withstand the peak test power.

Preferably, switches L (11) and M (12) are a MOSFET or BJT.
The invention further comprises a method to detect an erroneous power adapted comprising the following steps:
- Connecting a power adapter (2) to an electronic device (4) through means of the electronic device's input connector (3);
- Measuring the input voltage at the ADC (9);
- If the measured input voltage is below the power adapter voltage tolerance, turning switch L (11) OFF position, disconnecting the load (10) from the main power rail (15).
- If the measured input voltage is equal or above the power adapter voltage tolerance, turning Switch M (12) ON.

### DESCRIPTION OF FIGURES

Erro! A origem da referência não foi encontrada. is a graphical description of the required hardware for the erroneous power adapter detection system. The numerical references represent:
- (1): Power input to the power adapter.
- (2): Power adapter
- (3): Electronic device power input connector.
- (4): Electronic device.
- (5): Diode.
- (6): Power storage.
- (7): MCU power supply.
- (8): Voltage monitoring circuit.
- (9): ADC (Analog to Digital Converter).
- (10): Load.
- (11): Switch L.
- (12): Switch M.
- (13): MCU (Microcontroller unit).
- (14): Connection to the electronic device main power rail.
- (15): Electronic device main power rail.

### DETAILED DESCRIPTION

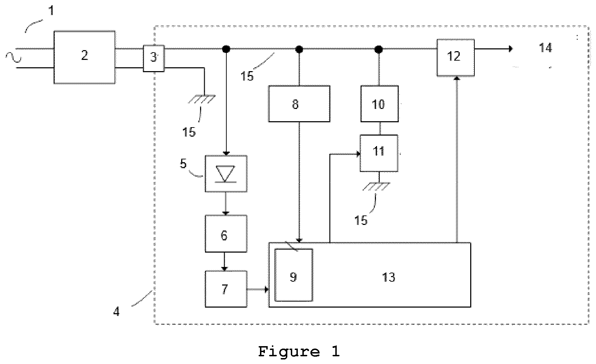

The following detailed description has references to Figure 1. Also, the following detailed description does not limit the scope of the disclosure.

The present invention relates to an erroneous power adapter detection system, depicted in Figure 1, comprising a power input to the power adapter (1), which can be Alternate Current (AC) or Direct Current (DC), and a power adapter (2), which can convert AC to DC or DC to DC. The typical application is AC to low-voltage DC. The output of the power adapter (2) is the line and return signals that connect to the electronic device power connector (3).

The diode (5) allows the current to flow only in the direction of the power storage (6) block. It can be a normal diode or an equivalent circuit. The power storage (6) storages enough power to allow the MCU (13) to perform the tests when the power adapter (2) is not the correct one, and powers off when loaded with the electronic device required power. Said power storage (6) is preferably implemented with a Capacitor or any other equivalent circuit. The MCU power supply (7) converts the electronic device input voltage to the voltage required by the MCU (13).

A voltage monitoring circuit (8) delivers a signal proportional to the electronic device input voltage to the MCU (13). Preferably, said voltage monitoring circuit (8) is a resistive voltage divider with a transient voltage suppressor to protect the MCU (13) from power spikes.

The ADC (9) performs the analog-to-digital conversion of the voltage signal and can be an external or internal ADC (9) of the MCU (13).

The load (10) must be calculated to pull the same power as the electronic device at its maximum power operation. Since the test will take just a few milliseconds, the load (10) is preferably a resistor with a lower sustained power capability than the required power. It must be able to withstand the peak test power. The switch L (11) and switch M (12) are electronically controlled switches connected to the MCU (13). They can be a MOSFET, BJT, or any type of electronically controlled switch. The switch L (11) connects the load (10) to the main power rail (15). The switch M (12) connects the main power rail to the electronic device's main power rail (15).

The MCU (13) is responsible for executing the software algorithm that conducts the test. The detection of the capabilities of the Power Adapter (2) necessitates the utilization of a synergistic combination of hardware and a software algorithm.

Here is a detailed exposition of the software algorithm:
Upon activation, the MCU (13) initiates its operations from a reset state and will run the program that will perform the test of the power adapter (2).

The following steps will be performed:
1) Switch M (12) will start in the OFF position. This disconnects the electronic device's main power rail (14) from the main power rail (15).
2) Switch L (11) is turned to the ON position. This will connect the LOAD (10) to the main power rail (15).
3) Wait for the necessary time to discharge any existing capacitor in the power adapter output circuit (2).
4) Measure the input voltage using the ADC (9).
5) Switch L (11) is turned to the OFF position, disconnecting the LOAD (10) from the main power rail (15) .
6) If the measured input voltage is below the power adapter voltage tolerance, raise a failure condition. If not, proceed with normal operation by turning Switch M (12) ON.

Steps 2 to 4 can be implemented in a PWM loop to put less strain on the connected power adapter (2).

As will be clear to one skilled in the art, the present invention should not be limited to the embodiments described herein, and several changes are possible that remain within the scope of the present invention.

Of course, the preferred embodiments shown above are combinable, in the different possible forms, being herein avoided the repetition of all such combinations.

## Claims

1. An erroneous power adapter detection device, comprising:
- A diode module (5) disposed in between the power storage (6) and the main power rail (15) adapted to allow the flow solely in the direction of the power storage (6);
- A power storage (6) disposed between to the MCU power supply (7) and said diode module (5) ;
- A MCU power supply unit (7) disposed between the power storage (6) and the MCU (7);
- A voltage monitoring circuit (8) adapted to deliver a signal proportional to the electronic device input to the MCU (13) and disposed between the main power rail (15) and the MCU (13);
- A load (10) connected to the main power rail (15) and to an electronically controlled switch (11), said switch connected to the main power rail return (15);
- A MCU (13) connected to the voltage monitoring circuit (8) and the load (10) adapted to perform the erroneous power detection method;
- an ADC (9) adapted to perform analog-to-digital conversion of the voltage signal;
- two electronically controlled switches L (11) disposed between the load (10) and the main power rail (15) and M (12) disposed between the main power rail (15) and the electronic device's main power rail (14).

2. An erroneous power detection device according to claim 1 wherein the load (10) is connected to the main power rail (15) through means of an electronically controlled switch (11).

3. An erroneous power detection device according to claims 1 and 2 wherein the power storage (6) is a capacitor or any equivalent circuit.

4. An erroneous power detection device according to claims 1 to 3 wherein voltage monitoring circuit (7) is a resistive voltage divider with a transient voltage suppressor adapted to protect the MCU (13) from power spikes.

5. An erroneous power detection device according to claims 1 to 5 wherein the load (10) is a resistor with a low sustained power capability adapted to withstand the peak test power.

6. An erroneous power detection device according to claim 7 wherein switches L (11) and M (12) are a MOSFET or BJT.

7. A method to detect an erroneous power adapted connection according to claims 1 to 8 comprising the following steps:
- Connecting a power adapter (2) to an electronic device (4) through means of the electronic device's input connector (3);
- Measuring the input voltage at the ADC (9);
- If the measured input voltage is below the power adapter voltage tolerance, turning switch L (11) OFF position, disconnecting the load (10) from the main power rail (15).
- If the measured input voltage is equal or above the power adapter voltage tolerance, turning Switch M (12) ON.

8. An erroneous power adapter detection system, comprising a device as described in claims 1 to 7 and a method as described in claim 8.
